# EUROPÄISCHE PATENTANMELDUNG

(11) **EP 1 187 332 A2**
(43) Veröffentlichungstag der Anmeldung: **13.03.2002**
(21) Anmeldenummer: 01119046.9
(22) Anmeldetag: 07.08.2001
(51) Int. Cl.: H03K 23/50, H03K 3/2885

(54) **Frequenzteilerschaltung**

(30) Priorität: 06.09.2000 DE 10043953
(71) Anmelder: Infineon Technologies AG, 81669 München (DE)
(72) Erfinder: Asam, Michael, 85250 Wollomoos (DE)
(74) Vertreter: Epping Hermann & Fischer

(57) **Zusammenfassung**

Es ist eine Frequenzteilerschaltung angegeben, welche lediglich zwei Differenzverstärker (DV1, DV2) aufweist. Den Differenzverstärkern (DV1, DV2) ist ein Takteingangssignal zu deren Aktivierung an Taktsignaleingängen (C, CX) zuführbar. An einem Haupt- und einem Hilfsausgang (I, IX, Q, QX) ist jeweils ein Signal halber Frequenz des Takteingangssignals ableitbar. Die Differenzverstärker (DV1, DV2) sind dabei über Kreuz gekoppelt. Die Frequenzteilerschaltung ist mit geringer Versorgungsspannung betreibbar und weist hohe Signalamplituden am Ausgang sowie hohe Flankensteilheit und geringes Phasenrauschen auf. Die Frequenzteilerschaltung ist beispielsweise in Hochfrequenz-Empfängern anwendbar.

## Beschreibung

Die vorliegende Erfindung betrifft eine Frequenzteilerschaltung.

Frequenzteiler sind digitale Schaltungen, bei denen die Eingangsfrequenzen ganzzahlige Vielfache der Ausgangsfrequenzen sind. Der einfachste Frequenzteiler besteht aus einem bistabilen T-Kippglied, welches die Eingangsfrequenz im Verhältnis 2:1 teilt.

Üblicherweise werden Frequenzteiler mit Master-Slave-Flip-Flops realisiert. Eine derartige Frequenzteilerschaltung ist beispielsweise aus Tietze, Schenk: Halbleiter-Schaltungstechnik, 10. Auflage, Seiten 235 bis 240 bekannt. Bei diesen bekannten Frequenzteilerschaltungen sind jedoch zumindest drei Transistor-Ebenen zwischen zwei Versorgungspotentialen übereinander angeordnet, so daß zur Versorgung derartiger, bekannter Frequenzteilerschaltungen verhältnismäßig große Versorgungsspannungen erforderlich und lediglich verhältnismäßig kleine Signalamplituden erzielbar sind.

Die großen Zuwachsraten bei mobilen, elektrisch betriebenen Geräten, beispielsweise im Kommunikations- oder Unterhaltungselektronik-Bereich, erfordern jedoch Schaltungen, welche für immer kleinere Versorgungsspannungen geeignet sind und einen geringen Stromverbrauch aufweisen.

Aufgabe der vorliegenden Erfindung ist es, eine Frequenzteilerschaltung anzugeben, welche für geringe Versorgungsspannungen geeignet ist und mit der große Signalamplituden erzielbar sind.

Erfindungsgemäß wird die Aufgabe mit einer Frequenzteilerschaltung gelöst, mit
- einem Eingang, dem ein Takteingangssignal mit einer zu teilenden Frequenz zuführbar ist,
- einem Hauptausgang und einem Hilfsausgang, an dem ein Taktausgangssignal mit einer geteilten Frequenz ableitbar ist,
- einem ersten Differenzverstärker, der eingangsseitig mit dem Hilfsausgang und ausgangsseitig mit dem Hauptausgang gekoppelt ist und
- einem zweiten Differenzverstärker, der eingangsseitig mit dem Hauptausgang und ausgangsseitig mit dem Hilfsausgang gekoppelt ist,
- wobei die Differenzverstärker mit dem Eingang gekoppelt sind.

Die beschriebene Frequenzteilerschaltung weist zwei Differenzverstärker auf, von denen in Abhängigkeit vom Takteingangssignal jeweils einer aktiv ist. Die am Haupt- beziehungsweise Hilfsausgang ableitbaren Taktausgangssignale können zueinander eine Phasenverschiebung von 90° aufweisen. Da für die beschriebene Frequenzteilerschaltung lediglich zwei Differenzverstärker erforderlich sind, ist diese mit geringem Strombedarf realisierbar. Zudem sind die Differenzverstärker und somit die Frequenzteilerschaltung für den Betrieb mit kleinen Versorgungsspannungen geeignet. Zugleich ermöglichen die Differenzverstärker große Signalamplituden der Taktausgangssignale.

In einer vorteilhaften Ausführungsform der vorliegenden Erfindung weist der erste Differenzverstärker Mittel zum Bereitstellen eines invertierten Signals und der zweite Differenzverstärker Mittel zum Bereitstellen eines nicht-invertierten Signals auf. Der erste Differenzverstärker stellt dabei ausgangsseitig am Hauptausgang das eingangsseitig anliegende Signal des Hilfsausgangs invertiert bereit. Der zweite Differenzverstärker stellt ausgangsseitig am Hilfsausgang das eingangsseitig anliegende Signal des Hauptausgangs nicht-invertiert bereit. Erster und zweiter Differenzverstärker sind in Abhängigkeit vom Takteingangssignal abwechselnd aktiv. Die Mittel zum Invertieren oder Nicht-Invertieren der Signale können dann besonders einfach ausgeführt sein, beispielsweise durch Verpolen von Anschlußpaaren, wenn die Taktausgangssignale als Differenzsignale vorliegen und Haupt- und Hilfsausgang mit je einem entsprechenden Anschlußpaar realisiert sind.

In einer weiteren, vorteilhaften Ausführungsform der Frequenzteilerschaltung weisen die Differenzverstärker Mittel zum Halten eines eingangsseitig anliegenden Signals auf. Zusätzlich zum Bereitstellen eines invertierten beziehungsweise nicht-invertierten Signals können die Differenzverstärker Mittel zum Halten des jeweils eingangsseitig anliegenden Signals aufweisen. Der erste Differenzverstärker hält dabei das Taktausgangssignal, welches am Hilfsausgang anliegt, und der zweite Differenzverstärker hält das am Hauptausgang anliegende Taktausgangssignal. Wenn die Differenzverstärker ohne zusätzliche Beschaltung invertierende Eigenschaften haben, so können die Mittel zum Halten dann besonders einfach realisiert sein, wenn die Taktausgangssignale als Differenzsignale vorliegen.

In einer weiteren, vorteilhaften Ausführungsform der vorliegenden Erfindung sind erster und zweiter Differenzverstärker an je eine mit dem Takteingangssignal schaltbare Stromquelle angeschlossen. Die Stromquellen können ersten und zweiten Differenzverstärker abhängig vom Takteingangssignal abwechselnd aktivieren. Die Frequenzteilerschaltung mit schaltbaren Stromquellen weist einen besonders einfachen Schaltungsaufbau auf. Die Stromquellen können bezugspotentialseitig an den Differenzverstärkern angeschlossen sein, wodurch sich eine weitgehende Unabhängigkeit der Schaltungseigenschaften von Schwankungen der Versorgungsspannung, welche die Frequenzteilerschaltung versorgt, ergibt.

In einer weiteren, vorteilhaften Ausführungsform der vorliegenden Erfindung sind erster und zweiter Differenzverstärker an je einen mit dem Takteingangssignal schaltbaren Emitterfolger angeschlossen. Hierdurch lassen sich die Differenzverstärker besonders schnell abschalten, was große Flankensteilheiten der Taktausgangssignale ermöglicht. Zudem eignet sich diese Ausführungsform für besonders niedrige Versorgungsspannungen und große Signalamplituden am Ausgang.

In einer weiteren, vorteilhaften Ausführungsform der vorliegenden Erfindung ist eingangsseitig an den Differenzverstärkern je ein Emitterfolger zur Kopplung mit Haupt- beziehungsweise Hilfsausgang angeschlossen. Hierdurch können die Amplituden des Taktausgangssignals noch weiter erhöht werden. Weiterhin ergibt sich eine noch größere Flankensteilheit, welche das Phasenrauschen der Frequenzteilerschaltung verringert. Die Emitterfolger wirken dabei als Impedanzwandler.

In einer weiteren, vorteilhaften Ausführungsform der vorliegenden Erfindung weisen die Differenzverstärker je vier emittergekoppelte npn-Transistoren auf, deren Emitteranschlüsse mit dem Eingang gekoppelt sind. Von den jeweils vier emittergekoppelten Transistoren können zwei emittergekoppelte Transistoren zum Bereitstellen des invertierten beziehungsweise nicht-invertierten Signals ausgangsseitig an den Differenzverstärkern vorgesehen sein und zwei weitere, emittergekoppelte Transistoren können zum Halten eines eingangsseitig am Differenzverstärker anliegenden Signals vorgesehen sein.

In einer weiteren, vorteilhaften Ausführungsform der vorliegenden Erfindung ist das Takteingangssignal den Emitteranschlüssen der Transistoren des ersten Differenzverstärkers nicht-invertiert und den Emitteranschlüssen der Transistoren des zweiten Differenzverstärker invertiert zuführbar.

Weitere Einzelheiten der vorliegenden Erfindung sind in den Unteransprüchen angegeben.

Die Erfindung wird nachfolgend an mehreren Ausführungsbeispielen anhand der Zeichnungen näher erläutert.

Es zeigen:
- Figur 1: ein Blockschaltbild eines ersten Ausführungsbeispiels der Erfindung,
- Figur 2: ein Blockschaltbild eines zweiten Ausführungsbeispiels der Erfindung,
- Figur 3: ein Blockschaltbild eines dritten Ausführungsbeispiels der Erfindung und
- Figur 4: ein Zustandsdiagramm der Taktein- und ausgangssignale gemäß den Frequenzteilerschaltungen von Figur 1 bis Figur 3.

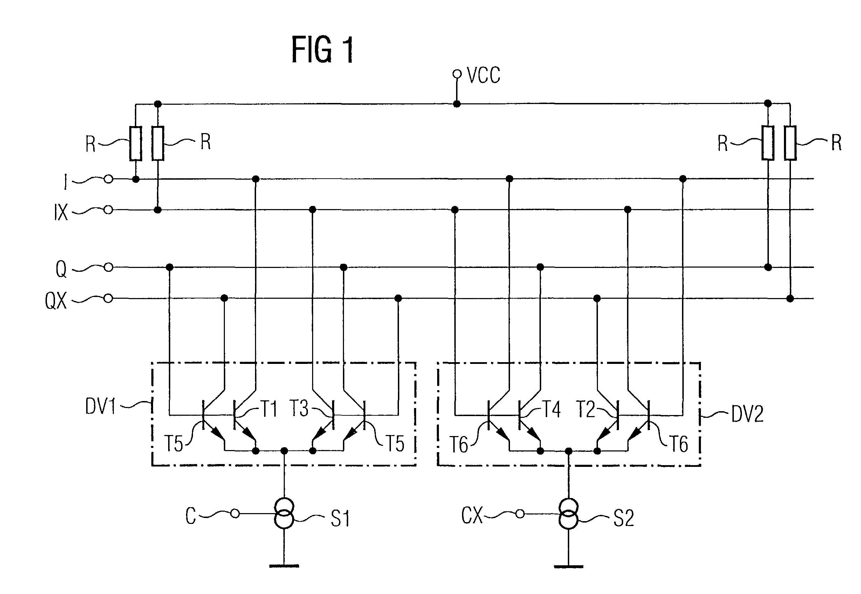

Figur 1 zeigt eine Frequenzteilerschaltung mit einem Eingang C, CX, der an Stromquellen S1, S2 zu deren Ansteuerung angeschlossen ist. Den schaltbaren Stromquellen S1, S2 wird ein Takteingangssignal dabei zum einen nicht-invertiert und zum anderen invertiert zugeführt. Die schaltbaren Stromquellen S1, S2 sind jeweils an eine gemeinsame Emitterleitung des ersten Differenzverstärkers DV1 beziehungsweise des zweiten Differenzverstärkers DV2 angeschlossen. Somit wird der erste Differenzverstärker DV1 vom am Eingang C anliegenden nicht-invertierten Takteingangssignal und der zweite Differenzverstärker DV2 vom am Eingang CX anliegenden invertierten Takteingangssignal angesteuert. Demnach sind erster und zweiter Differenzverstärker DV1, DV2 in Abhängigkeit vom Takteingangssignal abwechselnd aktiv.

Der erste Differenzverstärker DV1 ist eingangsseitig mit dem Hilfsausgang Q, QX und ausgangsseitig über ein erstes Transistorenpaar T1, T3 mit dem Hauptausgang I, IX derart verbunden, daß bei aktivem erstem Differenzverstärker DV1 am Hauptausgang I, IX das invertierte Signal des am Hilfsausgang Q, QX anliegenden Signals gebildet ist. Mit einem zweiten Transistorpaar T5 des ersten Differenzverstärkers DV1 ist eine Selbsthaltung des am Hilfsausgang Q, QX anliegenden Signals bei aktivem erstem Differenzverstärker DV1 gebildet. Über einen Versorgungsanschluß VCC sowie über Widerstände R, über die der Versorgungsanschluß VCC mit Hauptausgang I, IX und Hilfsausgang Q, QX verbunden ist, werden erster und zweiter Differenzverstärker DV1, DV2 versorgt. Haupt- und Hilfsausgang I, IX, Q, QX sind dabei mit je einem Anschlußpaar zum Bereitstellen von Differenzsignalen ausgeführt. Bei der Verschaltung der Differenzverstärker DV1, DV2 mit den Ausgängen I, IX, Q, QX sind die Differenzverstärkern üblicherweise anhaftenden invertierenden Eigenschaften zu beachten.

Die Frequenzteilerschaltung weist lediglich zwei Differenzverstärker DV1, DV2 auf und ist mit geringer Versorgungsspannung betreibbar, da nur wenige Transistorebenen vorgesehen sind. An den Ausgängen Q, QX, I, IX ist jeweils ein Signal mit halber Frequenz des am Taktsignaleingang C, CX anlegbaren Signals ableitbar, welches große Signalamplituden aufweist. Die beschriebene Frequenzteilerschaltung hat einen geringen Strombedarf. Da zwischen den Taktausgangssignalen eine Phasenverschiebung von 90 Grad gegeben ist, kann die Frequenzteilerschaltung beispielsweise in Empfängerschaltungen integriert werden, bei denen ein aus Inphase- und Quadraturkomponente bestehendes Trägersignal benötigt wird.

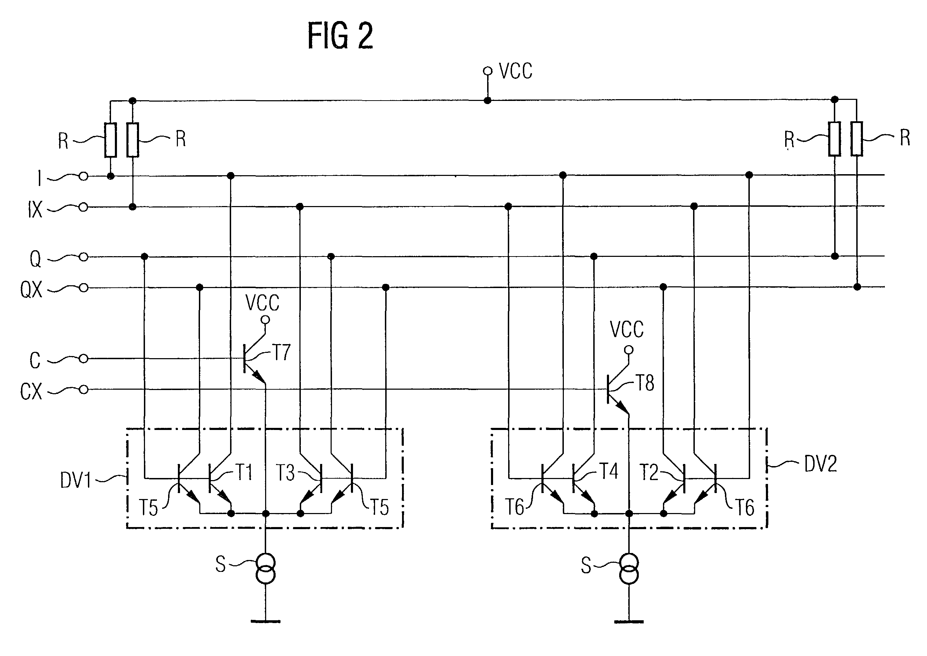

Figur 2 zeigt eine Weiterbildung der Frequenzteilerschaltung gemäß Figur 1, bei der anstelle von an den Emitterknoten des ersten beziehungsweise zweiten Differenzverstärkers DV1, DV2 angeschlossenen, schaltbaren Stromquellen S1, S2 zum ein- beziehungsweise ausschalten des ersten und zweiten Differenzverstärkers DV1, DV2 je ein Emitterfolger T7, T8 vorgesehen ist. Dabei sind die Emitterknoten jeweils an Stromquellen S angeschlossen, welche mit einem Anschluß für ein Bezugspotential verbunden sind. Der als Bipolar-Transistor ausgeführte Emitterfolger T7 ist an seinem Basisanschluß mit dem Taktsignaleingang C, mit seinem Emitteranschluß mit dem gemeinsamen Emitteranschluß des ersten Differenzverstärkers DV1 und mit seinem Kollektoranschluß mit dem Versorgungsanschluß VCC verbunden. In Analogie dazu ist der Emitterfolger T8 mit seinem Basisanschluß mit dem Taktsignaleingang CX, mit seinem Emitteranschluß mit dem gemeinsamen Emitteranschluß des zweiten Differenzverstärkers DV2 und mit seinem Kollektoranschluß mit dem Versorgungsanschluß VCC verbunden. Abgesehen von dieser Ansteuerung des ersten und zweiten Differenzverstärkers DV1, DV2 mit dem Takteingangssignal entspricht die Frequenzteilerschaltung gemäß Figur 2 derjenigen von Figur 1. Die Abschaltung der jeweils nicht aktiven Differenzverstärker-Stufe DV1, DV2 mit den Emitterfolgern T7, T8 erfolgt dabei durch potentialmäßiges Hochziehen des gemeinsamen Emitterknotens auf das am Versorgungsanschluß VCC anliegende Potential. Dies ermöglicht ein schnelleres Abschalten der Differenzverstärker DV1, DV2 als mit schaltbaren Stromquellen gemäß Figur 1, so daß hohe Flankensteilheiten bei den Taktausgangssignalen erzielbar sind. Zudem ermöglicht die beschriebene Frequenzteilerschaltung den Betrieb mit besonders geringer Versorgungsspannung und ermöglicht besonders große Signalamplituden an den für Differenzsignale ausgeführten Ausgängen I, IX, Q, QX.

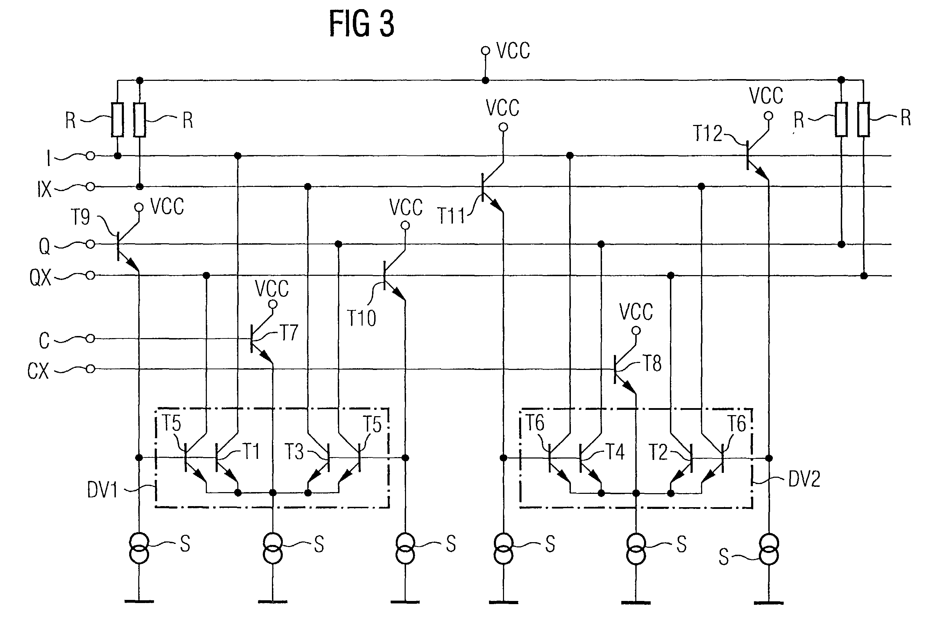

Figur 3 zeigt ein drittes Ausführungsbeispiel der Frequenzteilerschaltung, welches einer Weiterbildung der Frequenzteilerschaltung von Figur 2 entspricht. Dabei ist die Kopplung der Basisanschlüsse der Transistoren T1, T2, T3, T4, T5, T6 des ersten und zweiten Differenzverstärkers DV1, DV2 mit den Hilfs- bzw. Hauptausgängen Q, QX, I, IX dadurch verbessert, daß Emitterfolger T9, T10, T11, T12 zur eingangsseitigen Signalzuführung an den Differenzverstärkern DV1, DV2 vorgesehen sind. Die Basisanschlüsse der Emitterfolger T9, T10, T11, T12 sind dabei jeweils mit den entsprechenden Haupt- beziehungsweise Hilfsausgängen Q, QX, I, IX verbunden, während die Emitteranschlüsse der Emitterfolger T9 bis T12 jeweils mit den Basisanschlüssen der Transistoren T1 bis T6 der Differenzverstärker DV1, DV2 verbunden sind, welche zusätzlich über je eine Stromquelle S mit dem Bezugspotential verbunden sind.

Die Frequenzteilerschaltung gemäß Figur 3 mit den zusätzlichen Emitterfolgern T9 bis T12 ermöglicht noch größere Signalamplituden an den Haupt- beziehungsweise Hilfsausgängen I, IX, Q, QX, da die Emitterfolger T9 bis T12 höhere Ströme eingangsseitig an den Differenzverstärkern DV1, DV2 zur Verfügung stellen können. Die höhere Flankensteilheit bei der Frequenzteilerschaltung gemäß Figur 3 führt zu einem sehr geringen Phasenrauschen des Frequenzteilers.

In alternativen Ausführungsformen der Frequenzteilerschaltung können anstelle der beschriebenen npn-Transistoren auch pnp-Transistoren oder Feldeffekt-Transistoren verwendet werden. Selbstverständlich sind dann anstelle der beschriebenen Emitterfolger Sourcefolger vorzusehen.

Die beschriebenen Frequenzteilerschaltungen sind mit lediglich zwei Differenzverstärkern realisierbar und weisen folglich einen geringen Strombedarf auf. Die Stromquellen S sowie die schaltbaren Stromquellen S1, S2, welche jeweils bezugspotentialseitig beziehungsweise masseseitig vorgesehen sind, ermöglichen einen Betrieb der Frequenzteilerschaltung, der weitgehend unabhängig von Versorgungsspannungsschwankungen ist.

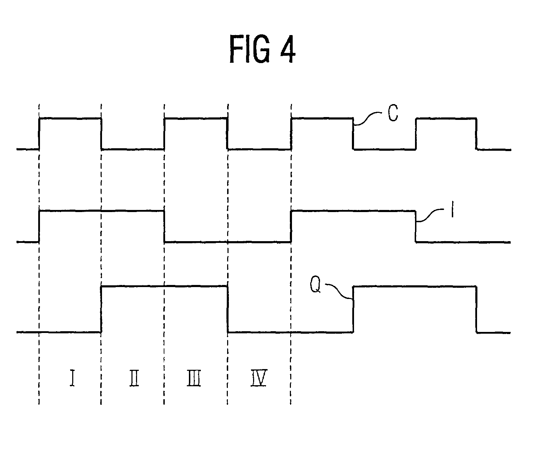

Figur 4 schließlich erläutert die Funktion der Frequenzteilerschaltungen gemäß Figuren 1 bis 3 anhand der Signalverläufe der Signale am Taktsignaleingang C sowie am Haupt- und Hilfsausgang I, Q. Dabei sind vier Taktphasen I, II, III, IV gebildet, welche jeweils periodisch aufeinander folgen. Man erkennt, daß das am Taktsignaleingang C zuführbare Signal die doppelte Frequenz wie die am Haupt- und Hilfsausgang I, Q ableitbaren Signale aufweist. Die am Haupt- und Hilfsausgang I, Q ableitbaren Signale sind zueinander um 90° phasenverschoben. Dabei ist das am Hauptausgang I, IX ableitbare Signal in Phase zum Takteinganssignal, während das am Hilfsausgang Q, QX ableitbare Signal eine Phasenverschiebung von 90° zeigt. Während der ersten und dritten Taktphase I, III ist der vom nicht-invertierten Taktsignal C angesteuerte, erste Differenzverstärker DV1 aktiv. Während zweiter und vierter Taktphase II, IV ist der vom hier nicht dargestellten, invertierten Taktsignal CX angesteuerte, zweite Differenzverstärker DV2 aktiv. Der erste Differenzverstärker DV1 bildet ausgangsseitig, das heißt am Hauptausgang I jeweils das invertierte Signal des am Hilfsausgang Q anliegenden Signals. Der zweite Differenzverstärker DV2 bildet ausgangsseitig, das heißt am Hilfsausgang Q jeweils das nicht-invertierte Signal des am Hauptausgang I anliegenden Signals.

## Patentansprüche

1. Frequenzteilerschaltung, mit
- einem Eingang (C, CX), dem ein Takteingangssignal mit einer zu teilenden Frequenz zuführbar ist,
- einem Hauptausgang (I, IX) und einem Hilfsausgang (Q, QX), an dem ein Taktausgangssignal mit einer geteilten Frequenz ableitbar ist,
- einem ersten Differenzverstärker (DV1), der eingangsseitig mit dem Hilfsausgang (Q, QX) und ausgangsseitig mit dem Hauptausgang (I, IX) gekoppelt ist und
- einem zweiten Differenzverstärker (DV2), der eingangsseitig mit dem Hauptausgang und ausgangsseitig mit dem Hilfsausgang gekoppelt ist,
- wobei die Differenzverstärker (DV1, DV2) mit dem Eingang (C, CX) gekoppelt sind.

2. Frequenzteilerschaltung nach Anspruch 1,
**dadurch gekennzeichnet, daß**
der erste Differenzverstärker (DV1) Mittel zum Bereitstellen eines invertierten Signals aufweist und der zweite Differenzverstärker (DV2) Mittel zum Bereitstellen eines nicht-invertierten Signals aufweist.

3. Frequenzteilerschaltung nach Anspruch 1 oder 2,
**dadurch gekennzeichnet, daß**
die Differenzverstärker (DV1, DV2) Mittel (T5, T6) zum Halten eines eingangsseitig anliegenden Signals aufweisen.

4. Frequenzteilerschaltung nach einem der Ansprüche 1 bis 3,
**dadurch gekennzeichnet, daß**
erster und zweiter Differenzverstärker (DV1, DV2) an je eine mit dem Takteingangssignal schaltbare Stromquelle (S1, S2) angeschlossen sind.

5. Frequenzteilerschaltung nach einem der Ansprüche 1 bis 3,
**dadurch gekennzeichnet, daß**
erster und zweiter Differenzverstärker (DV1, DV2) an je einen mit dem Takteingangssignal schaltbaren Emitterfolger (T7, T8) angeschlossen sind.

6. Frequenzteilerschaltung nach Anspruch 5,
**dadurch gekennzeichnet, daß**
eingangsseitig an den Differenzverstärker (DV1, DV2) je ein Emitterfolger (T9, T10, T11, T12) zur Kopplung mit Haupt- beziehungsweise Hilfsausgang (I, IX, Q, QX) angeschlossen ist.

7. Frequenzteilerschaltung nach einem der Ansprüche 1 bis 6,
**dadurch gekennzeichnet, daß**
die Differenzverstärker (DV1, DV2) jeweils vier emittergekoppelte npn-Transistoren (T1, T3, T5; T2, T4, T6) aufweisen, deren Emitteranschlüsse jeweils mit dem Eingang (C, CX) gekoppelt sind.

8. Frequenzteilerschaltung nach Anspruch 7,
**dadurch gekennzeichnet, daß**
das Takteingangssignal den Emitteranschlüssen der Transistoren (T1, T3, T5) des ersten Differenzverstärkers (DV1) nicht-invertiert und den Emitteranschlüssen der Transistoren (T2, T4, T6) des zweiten Differenzverstärkers (DV2) invertiert zuführbar ist.
